# EUROPÄISCHE PATENTSCHRIFT

(11) **EP 4 449 137 B1**
(45) Veröffentlichungstag und Bekanntmachung des Hinweises auf die Patenterteilung: **28.05.2025**
(21) Anmeldenummer: 22797650.3
(22) Anmeldetag: 20.10.2022
(51) Int. Cl.: G01R 31/34

(54) **VERFAHREN UND VORRICHTUNG ZUR PRÜFUNG EINES SMC-STATORKERNS**
METHOD AND DEVICE FOR TESTING AN SMC STATOR CORE
PROCÉDÉ ET DISPOSITIF DE TEST D'UN NOYAU DE STATOR SMC

(30) Priorität: 16.12.2021 DE 102021133457
(43) Veröffentlichungstag der Anmeldung: 23.10.2024
(73) Patentinhaber: Schaeffler Technologies AG & Co. KG, 91074 Herzogenaurach (DE)
(72) Erfinder: LINDNER, Andreas, 91054 Erlangen (DE)
(86) Internationale Anmeldenummer: PCT/DE2022/100772
(87) Internationale Veröffentlichungsnummer: WO 2023/109998

(56) Entgegenhaltungen:
- G. KRAUSE: "Abschlussbericht PriMa3D -Siebgedruckte Komponenten für elektrische Antriebe", 1 January 2016 (2016-01-01), XP055523866, Retrieved from the Internet <URL:https://www.tib.eu/en/search/download/?tx_tibsearch_search%5Bdocid%5D=TIBKAT%3A872401618&cHash=8782838235009100607ceb888b6a2c4e#download-mark> [retrieved on 20181114]
- HAN PENG ET AL: "Integrated Modular Motor Drives Based on Multiphase Axial-flux PM Machines with Fractional-slot Concentrated Windings", 2021 IEEE INTERNATIONAL ELECTRIC MACHINES & DRIVES CONFERENCE (IEMDC), IEEE, 17 May 2021 (2021-05-17), pages 1 - 6, XP033926990, DOI: 10.1109/IEMDC47953.2021.9449608
- PENNANDER L.-O. ET AL: "Design and Implementation of SMC Components for an Automotive Electric Water Pump", WORLDPM 2018, 16 September 2018 (2018-09-16), Beijing, China, XP093014302, Retrieved from the Internet <URL:https://www.hoganas.com/globalassets/download-media/technical-papers/smc/worldpm_2018_design20and20implementation20of20smc20components20for20an20automotive20electric20water20pump_pennander.pdf> [retrieved on 20230116]

## Beschreibung

Die Erfindung betrifft ein Verfahren zur Prüfung eines Statorkerns für eine elektrische Maschine, welche aus einem weichmagnetischen Komposit-Material (SMC = soft magnetic composite) gefertigt ist. Ferner betrifft die Erfindung eine Vorrichtung zur Prüfung eines solchen Statorkerns einer elektrischen Maschine, insbesondere eines Elektromotors.

Ein Elektromotor mit einem Statorkern aus einem SMC-Material ist beispielsweise aus der EP 2 901 541 B1 bekannt. Der Statorkern des bekannten Elektromotors ist topfartig ausgeformt, wobei am Topfrand zahnartige Vorsprünge angeordnet sind. Der Rotor des Elektromotors nach der EP 2 901 541 B1 weist eine Multilayer-Leiterplatte auf.

Weitere Gestaltungsmöglichkeiten von Statoren und Rotoren elektrischer Maschinen sind zum Beispiel in den Dokumenten EP 1 598 920 B1, DE 10 2012 207 414 A1 und WO 2018/027330 A1 beschrieben. Grundsätzlich können Zähne von Statoren oder Rotoren, wie beispielhaft aus diesen Dokumenten hervorgeht, entweder in Radialrichtung oder in Axialrichtung der betreffenden elektrischen Maschine ausgerichtet sein.

Pulverbasierte Werkstoffe stellen bekanntermaßen eine Alternative zu Stator- oder Rotorblechpaketen dar, um im Vergleich zu massiven metallischen, elektrisch leitfähigen Komponenten Wirbelstromverluste zu mindern, und kommen bei verschiedensten geometrischen Gestaltungen von Elektromotorkomponenten in Betracht. Im Vergleich zu Standardelektroblechen weisen Statorkerne aus SMC-Materialien aufgrund ihrer geringen elektrischen Leitfähigkeit typischerweise kaum Wirbelstromverluste, dagegen tendenziell mehr Kernverluste, das heißt Ummagnetisierungsverluste, auf.

Hinsichtlich eines ferromagnetischen Pulvers, welches für die Fertigung von Komponenten von Elektromotoren oder von Transformatoren geeignet ist, wird beispielhaft auf das Dokument US 9,640,306 B2 hingewiesen. In diesem Fall sind weichmagnetische Partikel von verschiedenen Schichten, unter anderem einer anorganischen isolierenden Schicht auf Phosphorbasis, umgeben.

In der Regel haben weichmagnetische Verbundmaterialien auf Pulverbasis, welche für die Verwendung in elektrischen Maschinen vorgesehen sind, magnetisch weitestgehend isotrope Materialeigenschaften. Abweichend hiervon weist zum Beispiel ein in der WO 2016/020077 A1 beschriebenes weichmagnetisches Komposit-Material eine hohe Anisotropie der Permeabilität auf.

Zur Bestimmung von Materialkenndaten weichmagnetischer Werkstoffe ist insbesondere das Ringkernmessverfahren geeignet. In diesem Zusammenhang wird auf folgende Dissertation hingewiesen:
Alexander Stadler: Messtechnische Bestimmung und Simulation der Kernverluste in weichmagnetischen Materialien, Technische Fakultät der Universität Erlangen-Nürnberg, Erlangen 2009

In dieser Dissertation wird eine Reihenschaltung aus mehreren gleichen Ringkernen vorgeschlagen. Der dabei erzielte Mittelungseffekt soll Streuungen innerhalb einer Charge verringern.

Im Abschlussbericht PriMa3D -Siebgedruckte Komponenten für elektrische Antriebevom 01.01.2026, G. Krause, XP055523866, siehe unter dem Link https://www.tib.eu/de/suchen/id/TIBKAT:86995413X/PriMa3D-Siebgedruckte-Komponenten-f%C3%BCr-elektrische?cHash=82083481b7de449ab70da525ffdb8386 ist auf Seite 18 in Kapitel 1.3.2 ein Verfahren zur Prüfung eines SMC-Statorkerns für eine elektrische Maschine beschrieben.

Die Publikation "Integrated Modular Motor Drives Based on Multiphase Axial-flux PM Machines with Fractional-slot Concentrated Windings", HAN PENG ET AL., 2021 IEEE INTERNATIONAL ELECTRIC MACHINES & DRIVES CONFERENCE (IEMDC), IEEE, 17. Mai 2021 (2021-05-17), Seiten 1-6, XP033926990, DOI: 10.1109/IEMDC47953.2021.9449608 beschreibt eine Machbarkeitsstudie und eine Leistungsbewertung der Verwendung von herkömmlichen Axialfluss-Permanentmagnetmaschinen (AFPM) mit konzentrierten Wicklungen mit Teilnuten in integrierten Motorantrieben (IMD) mit demselben Durchmesser und einer minimalen Zunahme der axialen Länge.

Die Publikation "Design and Implementation of SMC Components for an Automotive Electric Water Pump", Pennander L.-O. ET AL., präsentiert auf der WorldPM 2018, 16. September 2018, XP093014302, Beijing, China, siehe unter dem Link https://www.hoganas.com/globalassets/download-media/ technical-papers/smc/ wor-ldpm_2018_design20and20implementation20of20smc20compone nts20for20an20automotive20electric20water20pump_pennander.pdf beschreibt eine Analyse und einen Überblick über den Weg zur Herstellung eines SMC-basierten Elektromotors für eine Kühlwasserpumpe für ein Hybrid- oder vollelektrisches Auto.

Der Erfindung liegt die Aufgabe zugrunde, Fortschritte bei der Prüfung von SMC-Statorkernen gegenüber dem Stand der Technik zu erzielen, wobei auch im Rahmen der Serienfertigung von Elektromotoren oder Generatoren eine rationelle Prüfung möglich sein soll.

Diese Aufgabe wird erfindungsgemäß gelöst durch ein Verfahren zur Prüfung eines Statorkerns gemäß Anspruch 1. Das Verfahren ist mit einer Vorrichtung nach Anspruch 5 durchführbar. Im Folgenden im Zusammenhang mit der Prüfvorrichtung erläuterte Ausgestaltungen und Vorteile der Erfindung gelten sinngemäß auch für das Prüfverfahren und umgekehrt.

Das Verfahren, mit welchem ein Statorkern aus einem weichmagnetischen Komposit-Material prüfbar ist, umfasst folgende Schritte:
- Bereitstellung einer Mehrzahl an als gedruckte Schaltungen vorliegenden Wicklungen, welche jeweils Ausnehmungen aufweisen, die der Form und Anordnung von Zähnen eines zu prüfenden SMC-Statorkerns angepasst sind,
- Aufstecken der aufeinander gestapelten gedruckten Schaltungen auf die Zähne des SMC-Statorkerns,
- Abdecken der Anordnung aus SMC-Statorkern und gedruckten Schaltungen durch einen die Zähne kontaktierenden Eisenrückschlussring,
- Betreiben der gedruckten Schaltungen als Transformatorwicklungen unter Erfassung von Eigenschaften des hierbei als Transformatorkern fungierenden SMC-Statorkerns.

Die Erfindung geht von der Überlegung aus, dass weichmagnetische Materialien auf Pulverbasis grundsätzlich prüfbar sind, indem aus dem weichmagnetischen Material ein spezieller Prüfling geformt wird. Die Eigenschaften des Prüflings können dann insbesondere im Ringkernmessverfahren ermittelt werden. Nachteilig hierbei ist ein hoher Aufwand für die Probenpräparation sowie die Tatsache, dass die Geometrie des Prüflings nicht der Geometrie der für die Verwendung in einer elektrischen Maschine vorgesehenen Komponente entspricht.

Diese Nachteile sind bei dem anmeldungsgemäßen Prüfverfahren, welches den SMC-Statorkern bei der Prüfung in seiner endgültigen, für den Einbau in eine elektrische Maschine vorgesehenen Form verwendet, prinzipbedingt nicht gegeben. Von Vorteil ist darüber hinaus die Verwendung vorgefertigter gedruckter Schaltungen, die das Umwickeln einer Probe überflüssig machen und für nacheinander auch teilautomatisiert durchzuführende Prüfungen praktisch beliebig vieler Statorkerne zur Verfügung stehen.

Die aufeinander zu stapelnden gedruckten Schaltungen, welche auf den SMC-Statorkern zum Zweck der Prüfung aufzusetzen sind, können entweder manuell oder robotisch positioniert werden. Entsprechendes gilt für den Eisenrückschlussring. In jedem Fall wird ein Prüfaufbau hergestellt, welcher für eine Prüfung nach dem Transformatorprinzip vorgesehen ist. Ergänzend ist es möglich, eine Erwärmungsmessung durchzuführen.

Gemäß einer möglichen Ausgestaltung des Prüfungsverfahrens werden Primär- und Sekundärwicklungen, welche jeweils in Form von gedruckten Schaltungen vorliegen, alternierend auf den SMC-Statorkern aufgesteckt. Insgesamt werden beispielsweise acht oder mehr gedruckte Schaltungen, das heißt mindestens vier Primärwicklungen und mindestens vier Sekundärwicklungen, aufeinander gestapelt. Innerhalb des damit hergestellten, durch den Eisenrückschlussring komplettierten Transformators ist der Magnetkreis unter anderem durch den ringförmigen, zu prüfenden Statorkern geschlossen. Bei der Prüfung wird im Sinne einer Stromregelung ein zeitlich veränderlicher Strom eingeprägt, der einen magnetischen Fluss im Statorkern bewirkt. Durch den magnetischen Fluss wiederum wird in der Sekundärwicklung eine messtechnisch einfach und zuverlässig erfassbare elektrische Spannung induziert.

Entsprechend der Grundform der zu prüfenden SMC-Statorkerne weisen die gedruckten Schaltungen insbesondere eine Ringform mit gleichförmig am Umfang verteilten Ausnehmungen für jeweils einen Zahn des Statorkerns auf. Hierbei wird davon ausgegangen, dass sich die Zähne in Axialrichtung der elektrischen Maschine erstrecken. Die Dicke der gedruckten Schaltungen richtet sich nach der Höhe der Zähne des SMC-Statorkerns sowie der Anzahl an gedruckten Schaltungen, welche innerhalb einer Messanordnung aufeinander zu stapeln sind. Für verschiedene zu prüfende SMC-Statorkerne mit unterschiedlichen Abmessungen, insbesondere von einander abweichenden Durchmessern, können entsprechend unterschiedlich dimensionierte gedruckte Schaltungen zur Verfügung gestellt werden, wobei für die Durchführung und Auswertung der Messungen, mit welchen die magnetischen Eigenschaften bestimmt werden, eine einheitliche Mess- und Auswertevorrichtung genutzt werden kann.

Im Unterschied zum SMC-Statorkern, welcher in die spätere Serienfertigung elektrischer Maschinen eingeht, stellt der Eisenrückschlussring ausschließlich eine Komponente der Prüfvorrichtung dar. Bei dem Eisenrückschlussring kann es sich prinzipiell um ein massives metallisches Bauteil oder um eine aus Elektroblech aufgebaute Komponente handeln. Im letztgenannten Fall ist hinsichtlich des magnetischen Flusses ein Aufbau des Eisenrückschlussrings aus konzentrischen Ringen von Vorteil, was jedoch fertigungstechnisch anspruchsvoll ist. Fertigungstechnisch simpler, jedoch hinsichtlich des magnetischen Flusses und entstehender Wirbelströme weniger günstig, ist ein Aufbau des Eisenrückschlussrings aus aufeinander gestapelten ringscheibenförmigen Blechen.

Insbesondere für den Fall von Frequenzen im kHz-Bereich ist eine Fertigung des Eisenrückschlussring aus einem weichmagnetischen Komposit-Material auf Pulverbasis von Vorteil. Hierbei handelt es sich in vorteilhafter Ausgestaltung um dasselbe SMC-Material, aus welchem auch die zu prüfenden Statorkerne gefertigt sind.

Insgesamt eignet sich die Prüfvorrichtung insbesondere für die Wareneingangskontrolle einer industriellen Fertigungslinie, bei der SMC-Statorkerne vollautomatisiert in die Prüfvorrichtung eingesetzt und magnetisch vermessen werden. Eventueller Ausschuss, was Statorkerne betrifft, wird somit bereits zu Beginn der Fertigung erkannt.

Bei den zu fertigenden Elektromotoren, deren Statorkerne mittels des anmeldungsgemäßen Prüfverfahrens zu 100% geprüft werden, handelt es sich insbesondere um permanentmagneterregte Motoren. Die Motoren sind beispielsweise zur Verwendung in Cobots vorgesehen. Beispielhaft wird in diesem Zusammenhang auf die Dokumente EP 3 643 455 A1 und US 2021/0114239 A1 hingewiesen.

Nachfolgend wird ein Ausführungsbeispiel der Erfindung anhand einer Zeichnung näher erläutert. Hierin zeigen, teilweise schematisiert:
- Fig. 1: eine Vorrichtung zur Prüfung eines SMC-Statorkerns einer elektrischen Maschine,
- Fig. 2: den Statorkern der Anordnung nach Fig. 1,
- Fig. 3: einen innerhalb der Anordnung nach Fig. 1 auf den Statorkern aufgesetzten Eisenrückschlussring,
- Fig. 4: eine von mehreren in der Anordnung nach Fig. 1 zum Einsatz kommenden gedruckten Schaltungen,
- Fig. 5: einen zwei Statorkerne umfassenden Elektromotor in einer Explosionsdarstellung.

Eine insgesamt mit dem Bezugszeichen 1 gekennzeichnete Prüfvorrichtung dient der Prüfung von Statorkernen 2, welche in Elektromotoren 10 eingebaut werden. Jeder Statorkern 2 beschreibt eine Kronenform mit einem Ringabschnitt 4 und zahlreichen an diesen anschließenden, in Axialrichtung des Ringabschnitts 4 ausgerichteten Zähnen 3. Die Statorkerne 2 sind aus einem weichmagnetischen Komposit-Material, das heißt SMC-Material, gefertigt.

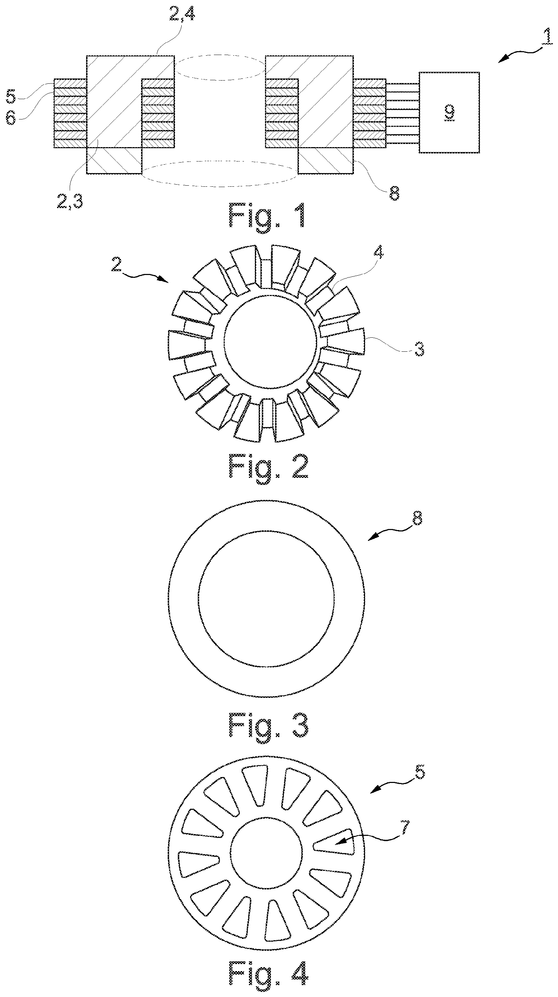

Die Prüfung der Statorkerne 2 wird mit gedruckten, ringscheibenförmigen Schaltungen 5, 6 durchgeführt. Jede gedruckte Schaltung 5, 6 weist Ausnehmungen 7 auf, deren Form und Anordnung der Querschnittsform der Zähne 3 entspricht. Innerhalb der Prüfvorrichtung 1 werden die gedruckten Schaltungen 5, 6 gestapelt auf die Zähne 3 des Statorkerns 2 aufgesetzt. Anschließend wird ein Eisenrückschlussring 8 auf die Stirnseiten der Zähne 3 aufgelegt, so dass sich die in Figur 1 skizzierte Anordnung ergibt. Die gedruckten Schaltungen 5, 6 werden, wie in Figur 1 angedeutet ist, derart an eine Auswerteeinheit 9 angeschlossen, dass alternierend eine gedruckte Schaltung 5 als Primärwicklung und eine gedruckte Schaltung 6 als Sekundärwicklung den Stapel an gedruckten Schaltungen 5, 6 bildet.

Während der Prüfung werden Primärwicklungen 5 bestromt. Die in den Sekundärwicklungen 6 induzierte elektrische Spannung wird mittels der Auswerteeinheit 9 gemessen. Nach Abschluss der durchgeführten Prüfungen wird der Statorkern 2 wieder aus der Prüfvorrichtung 1 entnommen. Der Statorkern 2, das heißt SMC-Statorkern, kann im Anschluss, ein positives Ergebnis der Prüfung seiner magnetischen Eigenschaften vorausgesetzt, als Komponente eines Elektromotors 10 verbaut werden.

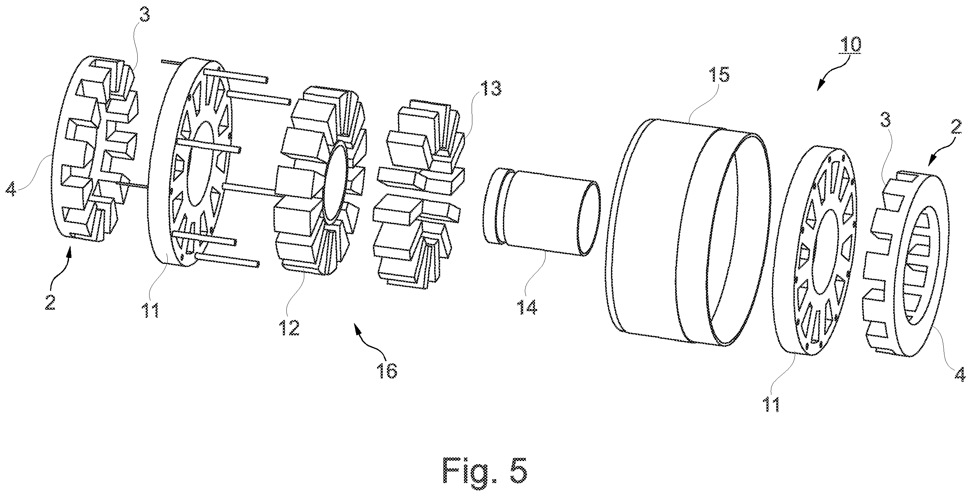

Beim Elektromotor 10, dessen Aufbau in Figur 5 illustriert ist, handelt es sich um einen bürstenlosen permanentmagneterregten Motor. Der Elektromotor 10 weist als elektrische Maschine an seinen beiden Stirnseiten spiegelbildlich zueinander angeordnete Statorkerne 2 auf, deren Zähne 3 aufeinander zu gerichtet sind. Die Zähne 3 eines jeden Statorkerns 2 greifen in jeweils eine Leiterplattenanordnung 11 ein, deren Grundform der Form der zu Prüfzwecken verwendeten gedruckten Schaltungen 5, 6 entspricht. Der insgesamt mit 16 bezeichnete Rotor des Elektromotors 10 umfasst ein aus SMC-Material gefertigtes Rotorblechpaket 12, in welches quaderförmige Permanentmagneten 13 eingefügt sind. Der Rotor 16 ist fest verbunden mit einer Welle 14 des Elektromotors 10. Das Gehäuse des Elektromotors 10 ist mit 15 bezeichnet. An sich bekannte Mittel zur Lagerung der Welle 14 sind in Figur 5 nicht dargestellt.

### Bezugszeichenliste

- 1: Prüfvorrichtung
- 2: Statorkern
- 3: Zahn
- 4: Ringabschnitt
- 5: Primärwicklung, gedruckte Schaltung
- 6: Sekundärwicklung, gedruckte Schaltung
- 7: Ausnehmung
- 8: Eisenrückschlussring
- 9: Auswerteeinheit
- 10: Elektromotor, elektrische Maschine
- 11: Leiterplattenanordnung
- 12: Rotorblechpaket
- 13: Permanentmagnet
- 14: Welle
- 15: Gehäuse
- 16: Rotor

## Patentansprüche

1. Verfahren zur Prüfung eines Soft-Magnetic-Composite-Statorkerns, SMC-Statorkerns (2), für eine elektrische Maschine (10), **gekennzeichnet durch** folgende Schritte:
- Bereitstellung einer Mehrzahl an als gedruckte Schaltungen (5, 6) vorliegenden Wicklungen, welche jeweils Ausnehmungen (7) aufweisen, die der Form und Anordnung von Zähnen (3) eines zu prüfenden SMC-Statorkerns (2) angepasst sind,
- Aufstecken der aufeinander gestapelten gedruckten Schaltungen (5, 6) auf die Zähne (3) des SMC-Statorkerns (2),
- Abdecken der Anordnung aus SMC-Statorkern (2) und gedruckten Schaltungen (5, 6) durch einen die Zähne (3) kontaktierenden Eisenrückschlussring (8),
- Betreiben der gedruckten Schaltungen (5, 6) als Transformatorwicklungen unter Erfassung von Eigenschaften des hierbei als Transformatorkern fungierenden SMC-Statorkerns (2).

2. Verfahren nach Anspruch 1, **dadurch gekennzeichnet, dass** Primär- und Sekundärwicklungen (5, 6) alternierend auf den SMC-Statorkern (2) aufgesteckt werden.

3. Verfahren nach Anspruch 2, **dadurch gekennzeichnet, dass** insgesamt mindestens acht gedruckte Schaltungen (5, 6) aufeinander gestapelt werden.

4. Verfahren nach einem der Ansprüche 1 bis 3, **dadurch gekennzeichnet, dass** der SMC-Statorkern (2), die gedruckten Schaltungen (5, 6) und der Eisenrückschlussring (8) robotisch zusammengesetzt werden.

5. Vorrichtung zur Prüfung eines Soft-Magnetic-Composite-Statorkerns, SMC-Statorkerns (2), für eine elektrische Maschine (10), **dadurch gekennzeichnet, dass** diese eine Mehrzahl an als gedruckte Schaltungen (5, 6) vorliegenden Wicklungen, welche jeweils Ausnehmungen (7) aufweisen, die der Form und Anordnung von Zähnen (3) eines zu prüfenden SMC-Statorkerns (2) angepasst sind, sowie einen die Zähne kontaktierenden Eisenrückschlussring (8) und eine zur Durchführung des Verfahrens nach einem der Ansprüche 1 bis 4 ausgebildete, zum elektrischen Anschluss an die Wicklungen (5, 6) vorgesehene Auswerteeinheit (9) umfasst.

6. Vorrichtung nach Anspruch 5, **dadurch gekennzeichnet, dass** die gedruckten Schaltungen (5, 6) jeweils eine Ringform mit gleichförmig am Umfang verteilten Ausnehmungen (7) aufweisen.

7. Vorrichtung nach Anspruch 5 oder 6, **dadurch gekennzeichnet, dass** die gedruckten Schaltungen (5, 6) jeweils Dicke aufweisen, welche nicht mehr als einem Achtel der Höhe der Zähne des SMC-Statorkerns (2) entspricht.

8. Vorrichtung nach einem der Ansprüche 5 bis 7, **dadurch gekennzeichnet, dass** der Eisenrückschlussring (8) aus Soft-Magnetic-Composite-Werkstoff, SMC-Werkstoff, gefertigt ist.

## Claims

1. A method for testing a soft magnetic composite stator core, SMC stator core (2), for an electric machine (10), **characterised by** the following steps:
- Provision of multiple windings in the form of printed circuits (5, 6), each of which has recesses (7) which are adapted to the shape and arrangement of teeth (3) of an SMC stator core (2) to be tested,
- Mounting of the stacked printed circuits (5, 6) on the teeth (3) of the SMC stator core (2),
- Covering of the arrangement of SMC stator core (2) and printed circuits (5, 6) with a ferrous flux ring (8) contacting the teeth (3),
- Operation of the printed circuits (5, 6) as transformer windings with recording of properties of the SMC stator core (2) acting in this case as the transformer core.

2. The method according to claim 1, **characterised in that** primary and secondary windings (5, 6) are alternately mounted on the SMC stator core (2).

3. The method according to claim 2, **characterised in that** a total of at least eight printed circuits (5, 6) are stacked on top of one another.

4. The method according to one of claims 1 to 3, **characterised in that** the SMC stator core (2), the printed circuits (5, 6) and the ferrous flux ring (8) are assembled robotically.

5. A device for testing a soft magnetic composite stator core, SMC stator core (2), for an electric machine (10), **characterised in that** this comprises multiple windings in the form of printed circuits (5, 6), each of which has recesses (7) which are adapted to the shape and arrangement of teeth (3) of an SMC stator core (2) to be tested, as well as a ferrous flux ring (8) contacting the teeth and an evaluation unit (9) designed for carrying out the method according to one of claims 1 to 4 and intended for electrical connection to the windings (5, 6).

6. The device according to claim 5, **characterised in that** the printed circuits (5, 6) each have a ring shape with recesses (7) distributed uniformly around the circumference.

7. The device according to claim 5 or 6, **characterised in that** the printed circuits (5, 6) each have a thickness which corresponds to no more than one eighth of the height of the teeth of the SMC stator core (2).

8. The device according to any of claims 5 to 7, **characterised in that** the ferrous flux ring (8) is made of soft magnetic composite material, SMC material.

## Revendications

1. Procédé de mise à l'essai d'un noyau de stator en composite à aimantation temporaire, noyau de stator SMC (2), pour une machine (10) électrique, **caractérisé par** les étapes suivantes :
- la mise à disposition d'une pluralité d'enroulements conçus sous la forme de circuits (5, 6) imprimés, lesquels comportent respectivement des évidements (7), lesquels sont adaptés à la forme et à l'agencement de dents (3) du noyau de stator SMC (2) à mettre à l'essai,
- l'emboîtement des circuits (5, 6) imprimés empilés les uns sur les autres sur les dents (3) du noyau de stator SMC (2),
- le recouvrement de l'agencement formé par le noyau de stator SMC (2) et les circuits (5, 6) imprimés par une bague de retour (8) en fer en contact avec les dents (3),
- le fonctionnement des circuits (5, 6) imprimés comme des enroulements de transformateur en détectant des propriétés du noyau de stator SMC (2) utiles en tant que noyau de transformateur.

2. Procédé selon la revendication 1, **caractérisé en ce que** des enroulements primaire et secondaire (5, 6) sont emboîtés en alternance sur le noyau de stator SMC (2).

3. Procédé selon la revendication 2, **caractérisé en ce qu'**au total au moins huit circuits (5, 6) imprimés sont empilés les uns sur les autres.

4. Procédé selon l'une quelconque des revendications 1 à 3, **caractérisé en ce que** le noyau de stator SMC (2), les circuits (5, 6) imprimés et l'anneau de retour (8) en fer sont assemblés de manière robotique.

5. Dispositif de mise à l'essai d'un noyau de stator en composite à aimantation temporaire, noyau de stator SMC (2), pour une machine (10) électrique, **caractérisé en ce que** celui-ci comprend une pluralité d'enroulements conçus sous la forme de circuits (5, 6) imprimés, lesquels comportent respectivement des évidements (7), lesquels sont adaptés à la forme et à l'agencement des dents (3) du noyau de stator SMC (2) à mettre à l'essai, ainsi qu'une bague de retour (8) en fer en contact avec les dents et une unité d'évaluation (9) conçue pour mettre en œuvre le procédé selon l'une quelconque des revendications 1 à 4 et destinée à être connectée de manière électrique aux enroulements (5, 6).

6. Dispositif selon la revendication 5, **caractérisé en ce que** les circuits (5, 6) imprimés présentent respectivement une forme annulaire comportant des évidements (7) répartis uniformément sur la périphérie.

7. Dispositif selon la revendication 5 ou 6, **caractérisé en ce que** les circuits (5, 6) imprimés présentent respectivement une épaisseur, laquelle n'est pas supérieure à un huitième de la hauteur des dents du noyau de stator SMC (2).

8. Dispositif selon l'une quelconque des revendications 5 à 7, **caractérisé en ce que** la bague de retour (8) en fer est réalisée en matériau composite à aimantation temporaire, matériau SMC.
